# EUROPEAN PATENT SPECIFICATION

(11) **EP 4 357 107 B1**
(45) Date of publication and mention of the grant of the patent: **19.03.2025**
(21) Application number: 23204378.6
(22) Date of filing: 18.10.2023
(51) Int. Cl.: B29C 63/00, B32B 43/00

(54) **FILM PEELING MACHINE**
FOLIENSCHÄLMASCHINE
MACHINE À DÉCOLLER LES FILMS

(30) Priority: 23.10.2022 JP 2022169551
(43) Date of publication of application: 24.04.2024
(73) Proprietor: ADTEC Engineering Co., Ltd., Tokyo 105-0001 (JP)
(72) Inventor: HIRAMATSU, Shunya, Tokyo, 1050001 (JP)
(74) Representative: Maiwald GmbH

(56) References cited:
- JP-A- H08 181 489
- JP-A- S62 113 145
- US-B1- 6 227 276
- US-B2- 8 997 821

## Description

### [Field of the Invention]

The present invention relates to a film peeling machine for peeling and removing a film laminated on a substrate.

### [Background of the Invention]

In manufacturing kinds of products, some processes are often carried out onto board-shaped workpieces (substrates) employed as bases. In manufacturing a product having a microstructure, for instance, a microfabrication process is carried out onto a substrate. In photolithography, which is a typical microfabrication process, a fine pattern is formed by a development and etching after an exposure of a resist layer (photosensitive layer) deposited on a substrate to a required light pattern. In such a manufacturing process where a final product is obtained after some processes onto a substrate, a film is sometimes laminated on the substrate as a temporary situation. This film is peeled off and removed if it can be an obstacle in a later process, or if it is unnecessary in the final product. In a light exposure process in photolithography, for instance, a substrate may be covered with a transparent film for protection. This protection film is peeled off after the light exposure process because it can be an obstacle in the development.

### [Prior Art Documents]

### [Patent Documents]

[Patent Document 1] JP S63 250190 A
[Patent Document 2] JP H06 171823 A
[Patent Document 3] JP 2007 131424 A
[Patent Document 4] US 8 997 821 B2
[Patent Document 5] JP S62 113145 A
[Patent Document 6] JP H08 181489 A
[Patent Document 7] US 6 227 276 B1

US 8 997 821 B2 describes a film peeling apparatus with the features of the preamble of claim 1. Other film peeling apparatuses are described in Patent Documents 5 to 7.

### [Disclosure of the Invention]

### [Problems the Invention will solve]

Under the described circumstance in this field, film peeling machines for peeling films laminated on substrates and removing them therefrom have been known. Among these, patent document 1 discloses a machine that applies a blade to a side of a substrate parallelly and peels off the film by levering up the edge of the blade. However, this kind of machines have the defect that layers under films could be damaged seriously because blades used therein have sharp edges. Hereafter in this specification, a layer under a film in a substrate is called "underlayer". An underlayer may be a substrate itself, or is a certain layer deposited on a substrate in many cases.

Patent document 2 discloses a machine that uses a sticking roller to peel off a film laminated on a substrate. However, a film clinging to a substrate is difficult to peel and remove only by applying the sticking roller thereto. The reason of this is that no so-called peeling initial is formed. "Peeling initial" means a film partially floats up (is separated) from an underlayer initially in peeling off the film. A gap is formed partially between the film and the underlayer, and then the film is pulled away therefrom. The machine in patent document 2 is deficient in peeling a film only by the sticking roller because no peeling initial is formed. Use of a highly-adhesive sticking roller might solve the difficulty. However, a peeled film is hard to be released from the highly-adhesive sticking roller, raising a problem in process automation.

Patent document 3 discloses a machine where a film is pressed with a knurling roller along a side of a substrate to form a surface roughness for the film peeling. In this machine, the surface roughness formed with the knurling roller works as a peeling initial, from which the film is pulled away. However, the machine in patent document 3 has the problem that a thin or vulnerable substrate could be damaged easily because the peeling initial is formed by pressing the knurling roller thereto. In addition, the knurling roller could tear the film partially, releasing broken pieces.

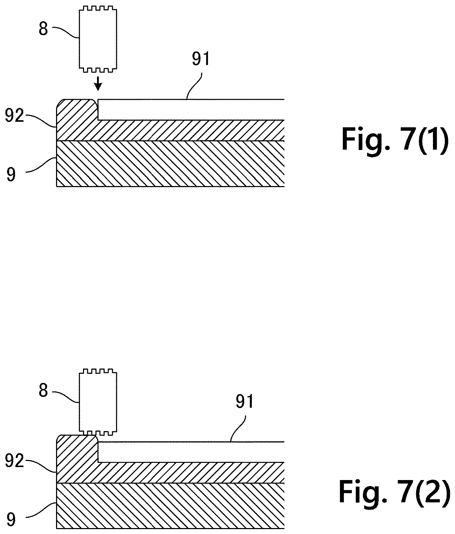

In the structure where an underlayer protrudes from an edge of a film, the machine in patent document 3 also has the problem that no adequate peeling initial is formed as well as the underlayer is scraped to release broken pieces. This point is described referring to Fig. 7 as follows. Fig. 7 is a cross sectional view showing a problem in the structure where an underlayer protrudes from an edge of a film in the conventional machine using the knurling roller. As shown in Fig. 7, a substrate 9 is sometimes not covered wholly with a film 91, from which an underlayer 92 protrudes. In this case, the underlayer 92 may swell, i.e., deform elastically or plastically, at the protrusion, becoming almost flush with the film 91 (Fig. 7(1)), or projecting from the film 91 (Fig. 7(2)). When a knurling roller 8 is pushed down in the situation shown in Fig. 7(1), the knurling roller 8 could touch and scrape the underlayer 92 due to the limited press position accuracy of the knurling roller 8. If this happens, the scraped underlayer 92 would release broken pieces. In the situation shown in Fig. 7(2), no adequate peeling initial can be formed, because the film 91 is not adequately pressed with the knurling roller 8.

The present invention has been made to solve the described problems in the prior art. That is, the object of the invention is to provide a film peeling machine that makes it possible to peel off a film without damaging, even if laminated on a vulnerable substrate, and makes it possible to suppress debris generation.

### [Means for solving the Problem]

To solve the described problems, this specification discloses a film peeling machine for peeling off a film laminated on a substrate in order to remove it therefrom. This film peeling machine is defined in present claim 1.

To solve the described problems, moreover, the jig applying mechanism in this film peeling machine may be a mechanism for making the vibration jig enter into the interface of the underlayer and the film at the edge thereof.

To solve the described problems, moreover, this film peeling machine may have a configuration where a supplementary jig is installed behind the vibration jig in the entering direction thereof, and the supplementary jig is installed in a position and posture where the film is kept apart from the underlayer after the film is detached from the underlayer when the vibration jig has entered into the interface.

To solve the described problems, moreover, this film peeling machine may have a configuration where the edge of the film is a corner, and the jig applying mechanism is a mechanism for applying the vibration jig to generate the ultrasonic vibration in the interface of the underlayer and the film at the corner thereof.

To solve the described problems, moreover, this film peeling machine may have a configuration where the jig applying mechanism is a mechanism for making the vibration jig enter into the interface of the underlayer and the film at the corner thereof.

To solve the described problems, moreover, the pull peel means in this film peeling machine may have a pincher to pinch and hold the edge of the film, a chuck to chuck and hold the edge of the film, or a sticker to stick to and hold the edge of the film.

To solve the described problems, moreover, this film peeling machine may have a peeling monitor for monitoring a peeling situation of the film. The peeling monitor may include a camera for capturing the whole substrate after the pulling-away means is operated, and an image processing module capable of judging whether the film has peeled off completely by processing image data from the camera.

To solve the described problems, moreover, this film peeling machine may have the configuration where a controller for controlling the vibration jig and the ultrasonic source is provided, and the controller carries out a control where the vibration jig is applied while it is ultrasonically vibrated by the ultrasonic source.

To solve the described problems, moreover, the vibration jig in this film peeling machine may be plate-shaped.

To solve the described problems, moreover, the vibration jig in this film peeling machine may be pin-shaped, wire-shaped, or rod-shaped.

### [Effects of the Invention]

As described below, the film peeling machine according to the disclosed invention does not need to use any sharp-edged blade that could damage an underlayer seriously because a peeling initial is created by ultrasonic vibration. The machine also makes process automation easier because an adequate peeling initial is formed, and can peel off a film laminated even on a vulnerable substrate without damaging it. In this, debris generation is suppressed because film tearing and underlayer scraping can be avoided.

In addition, the pull-away means enables the film peeling with further suppressed underlayer scraping.

In addition, the configuration where the jig applying mechanism makes the vibration jig enter into the interface brings with it the effect that the film peeling is made more stable and easier, because a peeling initial is formed in a wider area from the film edge.

In addition, the configuration where the supplementary jig is installed behind the vibration jig in the entering direction and keeps the film apart from the underlayer brings with it the effect that the pulling-away operation by the pull-away means is made more stable, because the film is prevented from re-adhering to the underlayer.

In addition, the configuration where the ultrasonic vibration is generated in the interface of the underlayer and the film at the corner to form a peeling initial brings with it the effect of making the film peeling further easier and reducing the debris generation further.

In addition, the configuration where the peeling monitor includes a camera for capturing the whole substrate after the pulling-away means is operated and an image processing module capable of judging whether a film has been peeled off completely by processing image data from the camera entails the effect that film peeling errors can be detected more reliably, because it can monitor partial residues of the film as well as whether the film peeling is completed properly.

In addition, the control where the vibration jig is applied ultrasonically vibrated brings with it the effect that the peeling initial is formed more efficiently, and accordingly the film peeling is made more efficiently, because the ultrasonic vibration is applied in advance to the interface through the propagation in air. This control also makes the film peeling more efficient, because making the vibration jig under the ultrasonic vibration enter into the interface is easier than making the vibration jig enter without ultrasonic vibration, i. e., generating the ultrasonic vibration after entering.

### [Brief Description of the Drawings]

Fig. 1 is a schematic front view of the film peeling machine in this embodiment.
Fig. 2 is a schematic plan view of the main part in the film peeling machine shown in Fig. 1.
Fig. 3 is a perspective view of the main part in the film peeling machine shown in Fig. 1.
Fig. 4 is a schematic plan view showing an operation of the film peeling machine in this embodiment.
Fig. 5 is a schematic front view showing the operation of the film peeling machine in this embodiment.
Fig. 6 is a schematic view showing a shape variation of the vibration jig.
Fig. 7 is a schematic cross-sectional view showing the problem of a conventional film peeling machine using a knurling roller when an underlayer protrudes from a film edge.

### [Mode to practice the Invention]

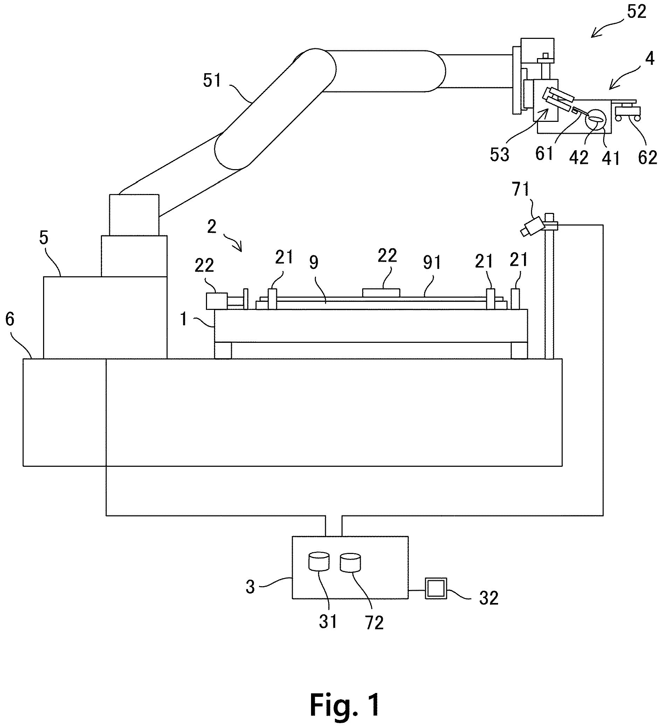

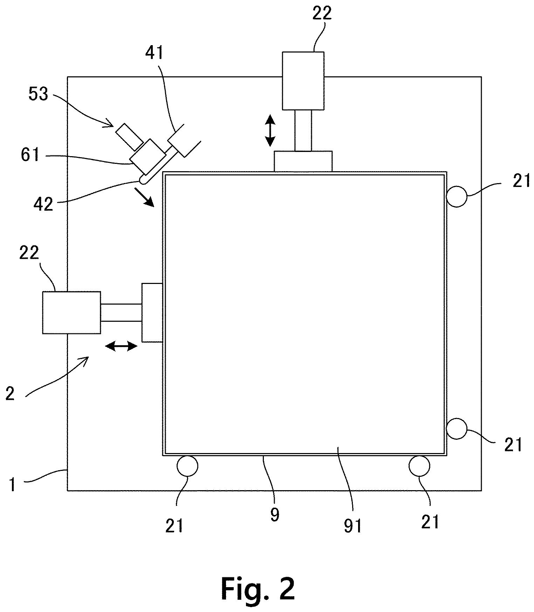

A mode (embodiment) in practicing the invention is described as follows. Fig. 1 is a schematic front view of the film peeling machine in this embodiment, and Fig. 2 is a schematic plan view of the main part in the film peeling machine shown in Fig. 1. As shown in Fig. 1, the film peeling machine in this embodiment has a stage 1 on which a substrate 9 is held in peeling a film 91. The stage 1 is table-like, having many vacuum chucking holes (not shown) on the top surface (substrate placing surface). Each vacuum chucking hole communicates with a vacuum pump (not shown) via channels formed in the stage 1 and an exhaust pipe (not shown), enabling the vacuum chuck of the substrate 9 on the top surface of the stage 1.

An auto-loader (not shown) is provided to the film peeling machine. A lift pin (not shown) installed in the stage 1 is lifted up to accept the substrate 9 when loading the substrate 9 by the auto loader, and then moved downwards to place the substrate 9 on the stage 1. Reversely in unloading the substrate 9 after the film peeling, the lift pin is lifted up to accept and raise the substrate 9, and moved downwards to the original position after the auto loader holds and unloads the substrate 9.

The film peeling machine in this embodiment is featured by the configuration where a peeling initial is formed at a corner of the film 91 for peeling off. The machine has an alignment mechanism 2 to form the peeling initial accurately at the corner of the film 91. As shown in Fig. 1 and Fig. 2, the alignment mechanism 2 includes column-shaped acceptors 21 fixed uprightly on the stage 1, and pushers 22 for pushing the substrate 9 placed on the stage 1 toward the acceptors 21. In this embodiment, the substrate 9 is square-shaped. A couple of pushers 22 are installed to push orthogonal sides of the substrate 9. The pushers 22 may be, for instance, air cylinders. Each acceptor 21 is fixed at a side opposite of a respective side where a pusher 22 for pushing the substrate 9 is arranged. In this example, a couple of the acceptors 21 (four in total) are each installed at neighboring sides opposite the other two sides. Each pusher 22 pushes against the substrate 9 and presses it against the opposite acceptors 21. This motion positions the substrate 9 at a position defined by the acceptors 21, thus accomplishing the alignment.

A controller 3 for controlling elements in the machine is provided as shown in Fig. 1. The controller 3 controls operations including the described load/unload of the substrate 9 and the alignment. A sequential program 31 is implemented on the controller 3. Operation control of each element is carried out through execution of the sequential program 31. The controller 3 also has a display 32 for displaying an operating situation and other information in the machine.

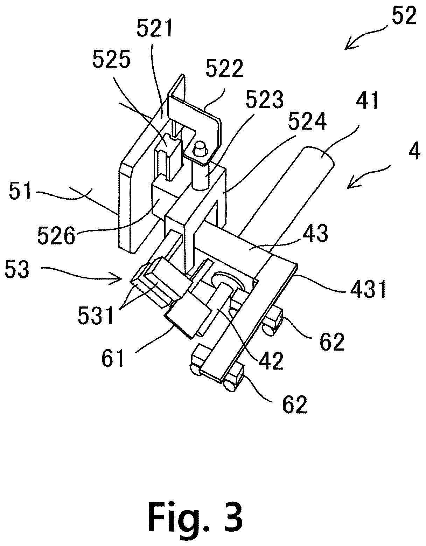

Referring to Fig. 3, elements for carrying out the film peeling operation for the aligned substrate 9 are described as follows. Fig. 3 is a perspective view of the main part in the film peeling machine shown in Fig. 1. A further feature of the film peeling machine in the embodiment is that a peeling initial is formed by utilizing ultrasonic vibration. For this configuration, an ultrasonic vibration unit 4 is installed as shown in Fig. 3. The ultrasonic vibration unit 4 includes an ultrasonic source 41 and a vibration jig 42 connected with the ultrasonic source 41.

The film peeling machine in the embodiment has a jig applying mechanism for applying the vibration jig 42 to generate an ultrasonic vibration in the interface of the underlayer and the film 91. In this embodiment, an articulated robot 5 is employed as the jig applying mechanism. As shown in Fig. 1, the machine has a base 6, on which the articulated robot 5 is installed. Fig. 3 shows a hand 52 mounted at the top of the arm 51 in the articulated robot 5.

As shown in Fig. 3, a base board 521 is fixed uprightly on the front end of the arm 51. A connecting plate 522 is fixed on the top of the base board 521, having a vertical axis pin 523 fitted therein. A forked board 524 is hung by the axis pin 523. A unit retaining rod 43 is fixed to the forked board 524, being inserted in the U-shaped opening thereof. A vertically elongated linear guide 525 is fixed on the front surface of the base board 521. A slider 526 is fixed on the back surface of the forked board 524. The slider 526 is fitted to the linear guide 525 and slidable thereon, enabling vertical movements of the forked board 524 and each fixed element. The axis pin 523 bears a ball screw mechanism, by which the vertical positions of the forked board 524 and the fixed elements are made adjustable. "Vertical" and "horizontal" in the postures of the elements shown in Fig. 3 depend on the position of the hand 52. They are changed when the position of the hand 52 is changed by an operation of the arm 51.

The ultrasonic vibration unit 4 is retained by the unit retaining rod 43. The unit retaining rod 43 has a through-hole, through which the ultrasonic source 41 is fitted. The vibration jig 42 is a plate-shaped element in this example. The vibration jig 42 is connected with the ultrasonic source 41, being elongated in the direction vertical to the length direction of the unit retaining rod 43. The cross section of the vibration jig 42, which can have various shapes, is thin-oval-shaped in this example. If necessary, the unit retaining rod 43 is supported by a horizontally-elongated rotatable shaft at the rear end in the forked board 524, being rotatable around the horizontal axis. The purpose of this is that angles of elements retained by the unit retaining rod 43 can be adjusted finely relative to the vertical direction.

A source generating 40 kHz ultrasonic waves, for instance, is used as the ultrasonic source 41. A commercially available ultrasonic cutter may be used without modification as the ultrasonic vibration unit 4. The material of the vibration jig 42, which is usually a metal such as steel (e.g., stainless steel) or aluminum, may also be ceramics or rigid plastic. The described ultrasonic vibration unit 4, which is a component of the hand 52, can be positioned at a required position by the articulated robot 5. The articulated robot 5 can also move the ultrasonic vibration unit 4 in a required direction, and can control the position of the ultrasonic vibration unit 4 as required. Operation of the ultrasonic source 41 is also controlled by the controller 3.

As elements to work in collaboration with the described ultrasonic vibration unit 4, the film peeling machine in the embodiment has a supplementary jig 61, a pulling-away means, and substrate restrainers 62. The supplementary jig 61 is an element for keeping the film 91 apart from the underlayer in collaboration with the vibration jig 42. The pulling-away means is a means for holding an edge of the film 91 to pull away the film 91. The substrate restrainers 62 are elements installed mainly for a height positioning.

As shown in Fig. 3, the supplementary jig 61 is a rectangular-shaped plate fixed to the unit retaining rod 43. Accordingly in this embodiment, the supplementary jig 61 moves together with the vibration jig 42. The supplementary jig 61 is installed slightly diagonally to the horizontal. The supplementary jig 61 is located behind the vibration jig 42 and a little higher than the vibration jig 42.

The articulated robot 5 also functions as a component of the pulling-away means. The hand 52 mounted on the top of the arm 51 in the articulated robot 5 is capable of holding an edge of the film 91. In this embodiment, the hand 52 has a pincher 53 for pinching the edge of the film 91. The pincher 53 in this example has a pair of pinching plates 531, a spring (not shown), and a plunger (not shown). For instance, the elasticity of the spring is made to act inward, i.e., directed to pinch, and the plunger works against the elasticity to expand the pinching plates. The plunger is one of control targets in the articulated robot 5, being controllable by the controller 3. As shown in Fig. 3, the pincher 53 is fixed to a side of the forked board 524.

Each tip of the pinching plates 531, which are apart from each other in the open state, is located adjacent to the rear end of the supplementary jig 61. The pinching plates 531 are disposed above each other, and the lower one is flush with the supplementary jig 61 in the open state, being inclined at the same angle.

As shown in Fig. 3, each substrate restrainer 62 is short-rectangle-bar-shaped and has two wheels (reference signs omitted) at the bottom. In peeling off the film 92, each substrate restrainer 62 is directed horizontally and makes the two wheels contact with the film 91. A couple of the substrate restrainers 62 are fixed to the unit retaining rod 43. An L-shaped plate 431 is fixed at the front end of the unit retaining rod 43. Each substrate restrainer 62 is fixed at the lower surface of an L-shaped plate 431. As shown in Fig. 3, the length direction of each substrate restrainer 62 corresponds with the length direction (back-and-forth direction) of the unit retaining rod 43. Each axis of each wheel is vertical to this direction.

The film peeling machine in the embodiment has a peeling monitor for monitoring a film peeling situation including proper completion of the film peeling. As shown in Fig. 1, the peeling monitor in this embodiment has a camera 71 capable of capturing the whole substrate 9, and an image processing module to process image data from the camera 71 and judge proper completion of the film peeling. The image processing module includes an image processing program 72 stored in a storage of the controller 3, and a processor (not shown) implemented in the controller 3.

Proper completion of the film peeling can be judged by image processing, because an image of a substrate 9 after the film peeling is different from that before. Lamination of a film 91 on a substrate 9 can be recognized because the edge of the film 91 is reflected in the image. Though edges of the substrate 9 and the film 91 may overlap when the film 91 has the same shape and size as the substrate 9, existence of the film 91 can be judged from such a difference as width difference of the line reflecting the edges and differences of the light diffraction on the edges. Even when the film 91 is torn and remains only partially, the residue can be recognized from an image reflecting the edge of a residual piece or from the light diffraction on the edge. The image processing program 72 includes a code to judge whether the film peeling is completed properly according to these factors in the image processing.

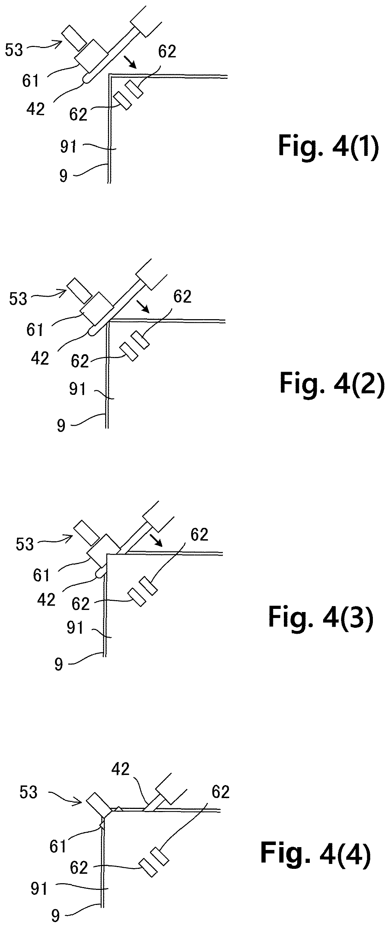

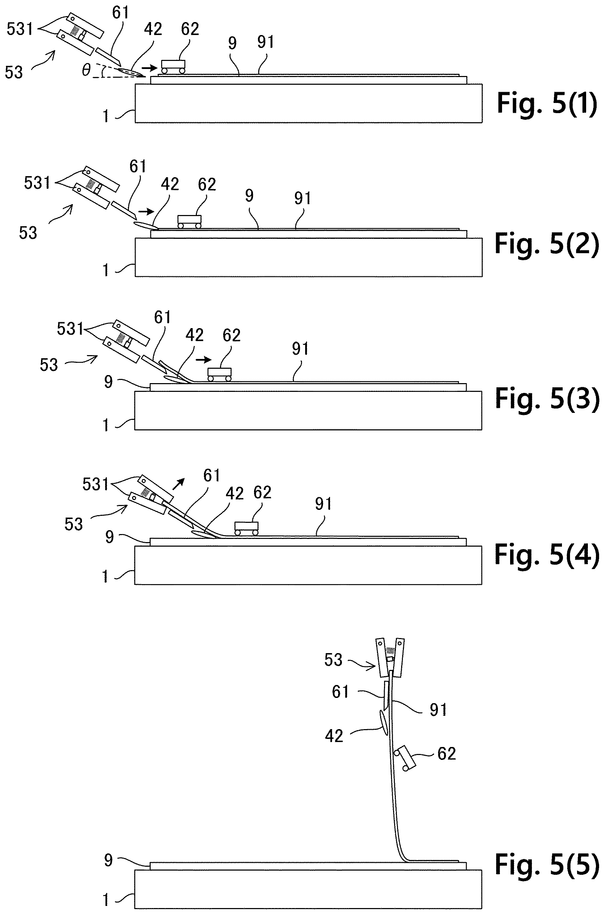

Operation of the film peeling machine having the above configuration is described below referring to Fig. 4 and Fig. 5. Fig. 4 is a schematic plan view showing the operation of the film peeling machine in this embodiment. Fig. 5 is a schematic front view showing the operation of the film peeling machine in this embodiment. A substrate 9 with a film 91 to be peeled off is placed on the stage 1 by the auto-loader (not shown). The film 91 covering the substrate 9 is, for instance, a protection film made of a material such as PET (polyethylene-terephthalate) transparent to an exposure wavelength. For instance, its thickness is about 10-20 microns. First of all, the controller 3 operates the alignment mechanism 2. The alignment is done by making each pusher 22 push the substrate 9 against the acceptors 21. Then the controller 3 opens a valve on the exhaust pipe connected to the vacuum pump, chucking the substrate 9 to the stage 1 by vacuum.

Next, the controller 3 sends a control signal to the articulated robot 5 to set the hand 52 on standby for the film peeling. As shown in Fig. 4(1), the hand 52 approaches and is positioned in a position adjacent to a corner of the film 91 in the standby state. The corner of the film 91 to which the hand 52 approaches is the place where a peeling initial is formed, being referred as "peeling initial corner" hereafter. As shown in Fig. 4(1), the length direction of the vibration jig 42 is vertical to the diagonal extending from the corner of the substrate 9 in the standby state. In every film peeling operation, the location of the peeling initial corner in every aligned substrate 9 is constant (fixed), being stored as preset control information in the controller 3. The controller 3 outputs a control signal to the articulated robot 5 to establish the positional relationship shown in Fig. (4) with this preset location.

As shown in Fig. 5(1), the vibration jig 42 is positioned at the same height as the interface of the film 91 and the underlayer in the standby state. More strictly, the front edge of the vibration jig 42 is positioned at the same height as the interface. The substrate restrainers 62 are used for carrying out this position control. In shifting to the standby state, the articulated robot 5 applies each substrate restrainer 62 to the film 91. When the hand 52 descends down from an upper position, each substrate restrainer 62 contacts with the film 91 and presses onto the substrate 9. The substrate 9 (the stage 1) presses back against the pressure, giving a load to the hand 52. The articulated robot 5 makes the hand 52 stop descending when this load is detected. This state when the descent stops is the state the height positioning of the hand 52 is completed.

In the hand 52, the vibration jig 42 and the substrate restrainers 62 are installed in a required height-positional-relationship to each other. In the required height-positional relationship the front edge of the vibration jig 42 is positioned lower from the bottoms of the substrate restrainers 62 (i.e., bottoms of the wheels) with the distance equal to the thickness of the film 91. Due to this positional relationship, the front edge of the vibration jig 42 is positioned at the same height as the interface of the film 91 and the underlayer when the substrate restrainers 62 are applied to the film 91 and the hand 52 stops descending. The height position adjustment of each substrate restrainer 62 is carried out by sliding the slider 526 on the linear guide 525. Concretely, a ball screw mechanism in the axis pin 523 enables the accurate fine adjustment of the height position. Alternatively, the height position adjustment is enabled by a configuration where the height position of the L-shaped plate 431 retaining each of the substrate restrainers 62 is made adjustable relative to the unit retaining rod 43. In any configuration, the height position of each of the substrate restrainers 62 is finely adjusted for any different thicknesses of films 91. As shown in Fig. 5(1), the width direction of the vibration jig 42 (i.e., direction of the major axis in the oval cross-sectional shape) is tilted slightly to the horizontal. The tilt angle, which is shown with "θ" in Fig. 5(1), is, for instance, about 0-70 degrees.

In the standby state, the controller 3 sends a control signal to the ultrasonic source 41 to start the operation. As a result, an ultrasonic vibration is generated on the vibration jig 42. Then the controller 3 sends a control signal to the articulated robot 5 to move the hand 52 forward. "Forward" is the horizontal direction along the diagonal of the square substrate 9, as shown with an arrow in Fig. 4(1). If the substrate 9 is not square but rectangular, the moving direction may be along the diagonal or may be 45 degrees (i.e., half of the corner angle). Otherwise, the moving direction may be within these angles, i.e., between the angle of the diagonal and the half angle of the corner angle. Moving forward as described, the vibration jig 42 under ultrasonic vibration is applied to the interface of the film 91 and the underlayer, as shown in Fig. 5(2). The vibration jig 42 applied to the interface generates an ultrasonic vibration therein.

In any of these cases, the interface is partially detached by the ultrasonic vibration, forming a gap. That is, a peeling initial is formed. After being applied to the interface, the hand 52 continues moving forward. The moving speed is slow, for instance, about 1-100 mm per second. During moving forward, because the peeling initial has been formed, the vibration jig 42 enters into the interface of the film 91 and the underlayer, as shown in Fig. 4(3) and Fig. 5(3).

The controller 3 controls the hand 52 to move further forward. Thus, the edge of film 91 is separated (i.e., floats) from the underlayer and rides on the supplementary jig 61 as shown in Fig. 4(3) and Fig. 5(3). Then, the edge reaches a position between the pinching plates 531 as guided by the supplementary jig 61. At this moment, the controller 3 sends a control signal to the articulated robot 5 to operate the pincher 53. As a result, the film 91 is pinched and held by the pincher 53 at the edge as shown in Fig. 4(4) and Fig. 5(4).

Next, the controller 3 sends a control signal to the articulated robot 5 to start the pulling-away operation. As shown in Fig. 5(5), the articulated robot 5 moves the hand 52 obliquely upward while the pincher 53 holds the edge of the film 91, and thereby completely detaches the film 91 from the underlayer. The moving direction of the hand 52 in this is the diagonal direction of the substrate 9 (otherwise 45 degrees or an angle between 45 degrees and the diagonal angle) in the horizontal plan view. After the pulling-away operation, the controller 3 sends a control signal to the articulated robot 5 to position the hand 52 above a waste box (not shown), and makes the pincher 53 carry out an opening operation, i.e., release operation. By this, the peeled film 91 is thrown into a waste box.

After making the articulated robot 5 carry out the operations necessary for completely peeling off the film 91 from the underlayer, the controller 3 sends a control signal to the camera 71 take a picture of the whole substrate 9. When the image data is returned from the camera 71, the controller 3 executes an image processing program 72 in order to judge whether the film peeling is completed properly. If so, the controller 3 stops the vacuum chuck of the substrate 9 and lifts up the lift pin for unloading. If judged as not completed properly, the controller 3 displays an error indication on the display 32.

In the described operation, the front edge of the vibration jig 42 is applied to the interface of the film 91 and the underlayer. This is a configuration where the vibration jig 42 is applied to both of the film 91 and the underlayer. In any configuration, a peeling initial is formed, enabling the film peeling, because an ultrasonic vibration is generated in the interface of the underlayer and the film 91 at the edge thereof.

The described film peeling machine in the embodiment does not need to use any sharp blade and accordingly does not have any problem of damaging an underlayer, either, because a peeling initial is formed by ultrasonic vibration. The machine has no difficulty in process automation because a sufficient peeling initial is formed, and can peel off a film laminated even on a vulnerable substrate 9. In addition, generation of broken pieces is suppressed, because the film 91 is not damaged, and because the underlayer is not scraped seriously either. The vibration jig 41, which enters and advances in the interface of the film 91 and the underlayer, forms a peeling initial in a wider area from the edge. This makes the film peeling more stable and easier.

The film peeling machine in the embodiment forms a peeling initial by applying the vibration jig 42 to the interface of the underlayer and the film 91 at a corner of a substrate 9. This configuration entails the effects of making the film peeling easier and of generating less debris. In forming a peeling initial by an ultrasonic vibration, the ultrasonic vibration may be generated by applying the vibration jig 42 not at a corner but at an intermediate (e.g., center) position on a side of the film 91. This configuration also enables the film peeling with less debris generation as compared to conventional machines. When the vibration jig 42 is applied at an intermediate position at a side, however, the generated ultrasonic vibration tends to diffuse widely. Due to this, it may be necessary to increase the vibration magnitude or apply the vibration for a longer period. By contrast, the configuration of the embodiment where the ultrasonic vibration is applied at a corner can form a peeling initial promptly without the necessity of enlarging the vibration magnitude or extending the vibration application period, because the vibration tends to remain confined locally. In addition, debris generation by scraping the underlayer is suppressed as well, because enlarging the vibration magnitude or extending the vibration application period is not necessary.

In the film peeling machine according to this embodiment, moreover, the pulling-away means can pull away the film 91 stably, because the supplementary jig 61 that keeps the film 91 apart from the underlayer prevents the film 91 from re-adhering. Without the supplementary jig 61, the edge of the film 91 may re-adhere to the underlayer, because the film 91 droops in those regions where the vibration jig 42 has passed while the vibration jig 42 under the ultrasonic vibration moves forward. If this happens, the operation ends with the pulling-away error becomes the pincher 53 is not able to pinch the edge of the film 91. Though use of a wider vibration jig 42 could be a solution, this has the defect of making the machine larger in scale, because the ultrasonic source 41 needs to be larger (i.e., of a high-output type). The supplementary jig 61 makes the machine free from this defect because a small-sized vibration jig 42 is enough for the film peeling.

The pulling-away means has the significant advantage of preventing the underlayer from being damaged in an area necessary for manufacturing the final product.

Only the vibration jig 42 is enough for peeling off a film 91 by ultrasonic vibration. The machine can have a configuration, for instance, where the vibration jig 42 under an ultrasonic vibration moves over the whole film-laminating area along the surface of the underlayer as the substrate 9 is sustained uprightly or as the substrate 9 is sustained upside down. In this configuration, the machine employs a vibration jig having a length longer than the width of the substrate 9 or longer than the diagonal of the substrate 9. This configuration, in which the peeled film 91 hangs down by its own weight, is rather impractical, because the underlayer would be damaged with high possibility while the vibration jig moves over the whole film laminating area. When the film 91 is a protection film used in an exposure step, for instance, a pattern fault could be caused after the development, resulting from the exposed (photo reacted) resist being damaged. Employment of the pulling-away means has the significant advantage of preventing such a problem. In a configuration where the pulling-away means is employed, the vibration jig 42 only has to move within a small area, not needing to move a long distance. That is, the pulling-away means can restrict the moving area of the vibration jig 42 to an area not necessary for the final product.

The control where the vibration jig 42 is applied under the ultrasonic vibration contributes to making the film peeling more efficient. When the vibration jig 42 approaches to the interface of the film 91 and the underlayer after an ultrasonic vibration has been generated thereon, the vibration propagates in advance through the air to the interface. Due to this, the interface in the state of already slightly vibrating accepts the vibration more easily when the vibration jig 72 is making immediate contact, forming a peeling initial more efficiently. In practicing the present invention, it is possible to generate an ultrasonic vibration on the vibration jig 42 after the vibration jig 42 enters into the interface. However, it is more preferable for the film peeling efficiency and easier to make the vibration jig 42 enter into the interface under an ultrasonic vibration.

The film peeling machine in the embodiment, which employs the peeling monitor for monitoring proper completion of a film peeling, can prevent a substrate 9 with a film not properly peeled off from being transferred to a next step. In this, the peeling monitor, which monitors proper completion of the film peeling by data processing of a whole substrate image shot by the camera 71, can recognize a partial residue of the film 91 as well. In a film peeling operation, a partial residue error often takes place when the film 91 is torn. The peeling monitor can detect this type of error. These merits of the peeling monitor are the same as in a film peeling machine not having the configuration of film peeling by ultrasonic vibration. For instance, a peeling monitor may be employed in any machine as disclosed in patent documents 1-3.

The pulling-away means, which holds a film 91 at the part where a peeling initial is formed and then pulls it away, may utilize alternatives to the pincher 53 pinching the edge of the film. For instance, a chuck to chuck the film 91 by negative pressure may be employed, or, alternatively, a sticking jig to hold the film 91 by adhesion may be employed. In these alternatives, the machine also may employ a mechanism to move the chuck with the chucked film 92 or the sticking jig with the stuck film 92, for pulling away. Use of the articulated robot 5 as the pulling-away means is not indispensable either. A simple mechanism such as one having a linear actuator and linear guide may be employed as well, because an element holding the edge of the film 92 (the hand 52 in the embodiment) only has to move in the pulling-away direction.

Though the pincher 53 and the vibration jig 42 both composing the pulling-away means are also components of the hand 52 and move together in the described embodiment, this configuration is not indispensable either. Though the advance of the vibration jig 42 is to make the film peeling easier by forming a peeling initial in a wider area, it does not have to accompany the advance of the pincher 53. After forming a peeling initial by the advance of the vibration jig 42, the pincher 53 may move independently (not together with other parts) to hold the edge of the film 91. This also applies for any configuration where the edge of the film 91 is held by chucking, sticking or the like. The configuration where those parts move together is, still, preferable, because the moving mechanism is simplified. The supplementary jig 61 as well does not need to be movable together with the vibration jig 42. Another moving mechanism may be provided for the supplementary jig 61 in addition to that for the vibration jig 42. In this case, the other mechanism moves the supplementary jig 61 to follow the vibration jig 42. Still, the moving-together configuration is preferable because of the mechanical simplification.

It is not indispensable either in the present invention for the vibration jig 42 to enter into the interface. A peeling initial formed by an ultrasonic vibration enables the pulling-away means to hold the film at that part and then to execute the pulling-away motion. In the described embodiment, alternatively, a chuck for chucking the film 91, for instance, may be installed in the hand 52. After applying the vibration jig 42 to an edge (e.g., a corner) of the film 91, the chuck holds the edge (i.e., the part where the peeling initial has been formed) and peels off the film 91 by a pulling-away motion. This configuration does not need to make the vibration jig 42 enter into the interface, but only needs to generate an ultrasonic vibration in the interface. Whereas the articulated robot 5 is commonly used as the jig applying mechanism in the described embodiment, another mechanism may be employed as jig applying mechanism. For instance, the machine may employ a mechanism simply for moving back and forth the vibration jig 42 in a horizontal direction, or, alternatively, may employ a mechanism for moving the vibration jig 42 linearly in horizontal and vertical directions.

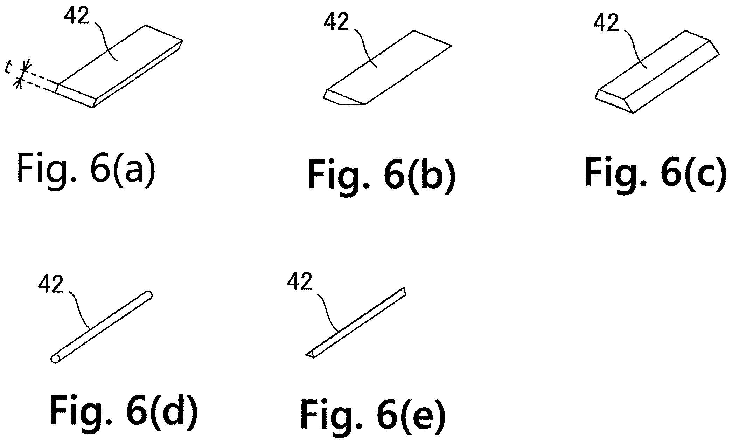

Whereas the vibration jig 42 in the described embodiment is a plate having a thin-oval cross-sectional shape, it can have various other configurations. This point is described referring to Fig. 6. Fig. 6 is a schematic view showing configuration variations of the vibration jig 42. The vibration jig 42 may be a plate having a simple rectangular cross-sectional shape as shown in Fig. 6(a), and may be any of the plates having knife edge fronts as shown in Fig. 6(b) and Fig. 6(c).

Each of those plate-shaped vibration jigs, including the one having a thin-oval cross-sectional shape, preferably have a rather small thickness (indicated by "t" in Fig. 6). The thickness t is preferably, for instance, about 0.1 mm to 5 mm. If the thickness t is more than 5 mm, the vibration jig is hard to enter into the interface of a film 91 and underlayer. A thickness less than 0.1 mm raises a problem in the strength, decreasing the durability. The vibration jig 42 having the configuration shown in Fig. 6(b) is preferably applied to an interface with the oblique front surface arranged horizontally.

Alternatively, long-shaped vibration jigs 42 shown in Fig. 6(d) and Fig. 6(e) may be employed. "Long-shaped" can be pin-shaped, wire-shaped, rod-shaped, or the like. Because the vibration jig preferably has the rigidity to keep the lengthened state, a string-shaped one is not always suitable. Still, a string-shaped vibration jig may be employed. Concretely, a string as a vibration jig is stretched with an adequate tension, and then an ultrasonic vibration is generated on the stretched string. The cross-sectional shape of a long-shaped vibration jig may be circle as shown in Fig. 6(d), or multangular (e.g., triangle, rectangle, pentagon, etc.) as shown in Fig. 6(e). The vibration jig 42 shown in Fig. 6(d) preferably has a diameter (outer diameter) within the described range of t. The vibration jig 42 shown in Fig.6 (e) preferably has a cross-sectional width along the direction vertical to the advance direction within the described range of t.

The alignment mechanism 2 is not indispensable either in the described embodiment. In a machine not employing the alignment mechanism 2, positions of substrates 9 placed on the stage 1 differ in every operation. Considering this, the machine may employ a configuration, for instance, where a corner position of a placed substrate 9 is detected by utilizing image data from the camera 71, i.e., by the image processing. The substrate restrainers 62 are also dispensable in the described film peeling machine. Instead of the substrate restrainers 62, the machine may employ, for instance, a camera for capturing a side of a substrate 9 for its height positioning. The height position of the substrate 9 is detected by processing image data from the camera. Alternatively, a distance meter may be installed at an upper basis position to measure the distance to a film 91 for the height positioning. If the thickness of films 91 is constant, a fixed height may be preset as the standby height for the vibration jig 42.

In peeling a film 91, though the substrate 9 suffers a force directed laterally, the position of the substrate 9 does not shift because the acceptors 21 work as stoppers. Accordingly, the vacuum chucking mechanism is dispensable in the machine. Even without the acceptors 21, the substrate 9 possibly remains stationary only by the frictional force on the stage 1 because the lateral force is not so high.

In the described operation of the film peeling machine, the vibration jig 42 may be applied to the film 91 initially. In this case, the film 91 might bend slightly and then resume the flat shape as the vibration jig 42 enters and advances beneath the film 91. Even in this case, the film peeling is carried out properly. The vibration jig 42 also may be applied to an underlayer initially. In this case, the underlayer might be slightly scraped as well as it might be deformed elastically or plastically as the vibration jig 42 advances. Even in this case, the debris generation is suppressed to a small amount because the advance distance of the vibration jig 42 is short. Particularly when the vibration jig 42 is applied to a corner and advances, the generation of broken or scraped-off pieces is suppressed to a small amount. Even if the underlayer suffers a deformation by scraping or a plastic deformation, no problem is raised because the vibration jig 42 only advances a short distance within an area not necessary for the final product.

Whereas, in the described embodiment, the film 91 is a protection film used in an exposure, it may be a different one. For example, in a process, a masking film is laminated on a substrate with a certain purpose and removed in a later step. In this process, the film peeling machine of the described embodiment can be used to remove the masking film. In practicing the present invention, the underlayer, which is often a dry film resist layer or solder resist layer, may be such a functional layer as an interlayer insulation film.

### [Explanation of Reference Signs]

- 1: Stage
- 2: Alignment Mechanism
- 3: Controller
- 31: Sequence Program
- 4: Ultrasonic Vibration Unit
- 41: Ultrasonic Source
- 42: Vibration Jig
- 5: Articulated Robot
- 51: Arm
- 52: Hand
- 53: Pincher
- 61: Supplementary Jig
- 62: Substrate Restrainer
- 71: Camera
- 72: Image Processing Program
- 9: Substrate
- 91: Film
- 92: Underlayer

## Claims

1. A film peeling machine for peeling off a film (91) laminated on a substrate (9), and then removing it therefrom, comprising;
a vibration jig (42),
an ultrasonic source (41) for generating an ultrasonic vibration on the vibration jig (42), and
a jig applying mechanism (5) for applying the vibration jig (42) to generate an ultrasonic vibration, and further comprising a pulling-away means (53) for holding the edge of the film (91) where the ultrasonic vibration has been generated and then pulling the film (91) away,
**characterized in that**
the jig applying mechanism (5) is adapted to position and move the vibration jig (42) so that the ultrasonic vibration is generated in an interface of the film (91) and an underlayer (92) at the edge of the film (91), with the vibration jig (42) making immediate contact with the film (91) and the underlayer (92), the underlayer (92) being a layer formed under the film (91) on the substrate (9).

2. The film peeling machine as claimed in the claim 1,
wherein the jig applying mechanism (5) is a mechanism to make the vibration jig (42) enter into the interface between the edge of the film and the underlayer.

3. The film peeling machine as claimed in the claim 2,
wherein a supplementary jig (61) is installed behind the vibration jig (42) in an entering direction thereof and
the supplementary jig (61) is installed in a position and posture where the film (91) is kept apart from the underlayer (92) after the film is detached from the underlayer when the vibration jig enters into the interface.

4. The film peeling machine, as claimed in the claim 1,
wherein the edge of the film (91) is a corner of the film, and
the jig applying mechanism (5) is a mechanism for applying the vibration jig (42) so as to generate the ultrasonic vibration in the interface of the film and the underlayer at the corner of the film.

5. The film peeling machine as claimed in the claim 4,
wherein the jig applying mechanism (5) is a mechanism for making the vibration jig (42) enter into the interface of the film and the underlayer at the corner of the film.

6. The film peeling machine as claimed in the claim 5,
wherein a supplementary jig (61) is installed behind the vibration jig (42) in an entering direction, and the supplementary jig is installed in a position and posture where the film (91) is kept apart from the underlayer (92) after the film is detached from the underlayer when the vibration jig (42) has entered into the interface.

7. The film peeling machine as claimed in any one of the previous claims,
wherein the pulling-away means has a pincher (53) to pinch and hold the edge of the film (91), a chuck to chuck and hold the edge of the film, or a sticking jig to stick and hold the edge of the film.

8. The film peeling machine, as claimed in any one of the previous claims,
further comprising a peeling monitor for monitoring a film peeling situation,
wherein the peeling monitor has a camera (71) for capturing the whole substrate after the pulling-away means (53) is operated, and an image processing module to judge whether the film was peeled off completely by processing image data from the camera.

9. The film peeling machine as claimed in any one of the previous claims,
further comprising a controller (3) for controlling the vibration jig (42) and the ultrasonic source (41),
wherein the controller (3) is capable of carrying out a control where the vibration jig is applied to make immediate contact with the film (91) and the underlayer (92) while it is ultrasonically vibrated by the ultrasonic source.

10. The film peeling machine as claimed in any one of the previous claims,
wherein the vibration jig (42) is plate-shaped.

11. The film peeling machine as claimed in any one of the previous claims,
wherein the vibration jig (42) is pin-shaped, wire-shaped, or rod-shaped.

## Patentansprüche

1. Folienablösemaschine zum Ablösen einer auf ein Substrat (9) laminierten Folie (91) und zum anschließenden Entfernen derselben von diesem, umfassend
eine Vibrationsvorrichtung (42),
eine Ultraschallquelle (41) zum Erzeugen einer Ultraschallschwingung auf der Vibrationsvorrichtung (42), und
einen Vorrichtungsanwendungsmechanismus (5) zum Anwenden der Vibrationsvorrichtung (42), um eine Ultraschallschwingung zu erzeugen, und
weiter eine Abzieheinrichtung (53) zum Halten des Randes der Folie (91), wo die Ultraschallschwingung erzeugt wurde, und zum anschließenden Abziehen der Folie (91),
**dadurch gekennzeichnet, dass**
der Vorrichtungsanwendungsmechanismus (5) dazu ausgebildet ist, die Vibrationsvorrichtung (42) so zu positionieren und bewegen, dass die Ultraschallschwingung in einer Grenzfläche der Folie (91) und einer Unterschicht (92) am Rand der Folie (91) erzeugt wird, wobei die Vibrationsvorrichtung (42) unmittelbar mit der Folie (91) und der Unterschicht (92) in Kontakt kommt, wobei die Unterschicht (92) eine unter der Folie (91) auf dem Substrat (9) gebildete Schicht ist.

2. Folienablösemaschine nach Anspruch 1,
wobei der Vorrichtungsanwendungsmechanismus (5) ein Mechanismus ist, der die Vibrationsvorrichtung (42) in die Grenzfläche zwischen dem Rand der Folie und der Unterschicht eindringen lässt.

3. Folienablösemaschine nach Anspruch 2,
wobei eine zusätzliche Vorrichtung (61) hinter der Vibrationsvorrichtung (42) in einer Eintrittsrichtung derselben installiert ist, und
die zusätzliche Vorrichtung (61) in einer Position und Haltung installiert ist, in der die Folie (91) von der Unterschicht (92) getrennt gehalten wird, nachdem die Folie von der Unterschicht abgelöst wurde, wenn die Vibrationsvorrichtung in die Grenzfläche eintritt.

4. Folienablösemaschine nach Anspruch 1,
wobei der Rand der Folie (91) eine Ecke der Folie ist, und
der Vorrichtungsanwendungsmechanismus (5) ein Mechanismus zum Anwenden der Vibrationsvorrichtung (42) derart ist, dass die Ultraschallschwingung in der Grenzfläche der Folie und der Unterschicht an der Ecke der Folie erzeugt wird.

5. Folienablösemaschine nach Anspruch 4,
wobei der Vorrichtungsanwendungsmechanismus (5) ein Mechanismus ist, der bewirkt, dass die Vibrationsvorrichtung (42) in die Grenzfläche der Folie und der Unterschicht an der Ecke der Folie eindringt.

6. Folienablösemaschine nach Anspruch 5,
wobei eine zusätzliche Vorrichtung (61) hinter der Vibrationsvorrichtung (42) in einer Eintrittsrichtung installiert ist, und
die zusätzliche Vorrichtung in einer Position und Haltung installiert ist, in der die Folie (91) von der Unterschicht (92) getrennt gehalten wird, nachdem die Folie von der Unterschicht abgelöst wurde, wenn die Vibrationsvorrichtung in die Grenzfläche eingetreten ist.

7. Folienablösemaschine nach einem der vorhergehenden Ansprüche,
wobei die Abzieheinrichtung eine Klemme (53) zum Einklemmen und Halten des Randes der Folie (91), eine Spannvorrichtung zum Einspannen und Halten des Randes der Folie oder eine Klebevorrichtung zum Anhaften und Halten des Randes der Folie aufweist.

8. Folienablösemaschine nach einem der vorhergehenden Ansprüche,
die weiter einen Abziehmonitor zur Überwachung einer Folienabziehsituation umfasst,
wobei der Abziehmonitor eine Kamera (71) zum Erfassen des gesamten Substrats nach dem Betätigen der Abzieheinrichtung (53) und ein Bildverarbeitungsmodul zum Beurteilen, ob die Folie vollständig abgezogen wurde, durch Verarbeiten von Bilddaten von der Kamera aufweist.

9. Folienablösemaschine nach einem der vorhergehenden Ansprüche,
die ferner eine Steuerung (3) zum Steuern der Vibrationsvorrichtung (42) und der Ultraschallquelle (41) umfasst,
wobei die Steuerung (3) in der Lage ist, eine Steuerung auszuführen, bei der die Vibrationsvorrichtung (42) so angewendet wird, dass sie in unmittelbaren Kontakt mit der Folie (91) und der Unterschicht (92) kommt, während sie von der Ultraschallquelle in Ultraschallschwingungen versetzt wird.

10. Folienablösemaschine nach einem der vorhergehenden Ansprüche,
wobei die Vibrationsvorrichtung (42) plattenförmig ist.

11. Folienablösemaschine nach einem der vorhergehenden Ansprüche,
wobei die Vibrationsvorrichtung (42) stiftförmig, drahtförmig oder stabförmig ist.

## Revendications

1. Machine à décoller des films pour décoller un film (91) stratifié sur un substrat (9), et ensuite le retirer de celui-ci, comprenant :
un gabarit de vibration (42),
une source d'ultrasons (41) pour générer une vibration ultrasonore sur le gabarit de vibration (42), et
un mécanisme d'application de gabarit (5) pour appliquer le gabarit de vibration (42) afin de générer une vibration ultrasonore, et
comprenant en outre des moyens d'arrachement (53) pour maintenir le bord du film (91) là où la vibration ultrasonore a été générée et arracher ensuite le film (91),
**caractérisée en ce que**
le mécanisme d'application de gabarit (5) est adapté pour positionner et déplacer le gabarit de vibration (42) de sorte que la vibration ultrasonore est générée dans une interface du film (91) et d'une sous-couche (92) au bord du film (91), avec le gabarit de vibration (42) faisant contact immédiat avec le film (91) et la sous-couche (92), la sous-couche (92) étant une couche formée sous le film (91) sur le substrat (9).

2. Machine à décoller des films selon la revendication 1, dans laquelle le mécanisme d'application de gabarit (5) est un mécanisme destiné à faire entrer le gabarit de vibration (42) dans l'interface entre le bord du film et la sous-couche.

3. Machine à décoller des films selon la revendication 2,
dans laquelle un gabarit supplémentaire (61) est installé derrière le gabarit de vibration (42) dans une direction d'entrée de celui-ci et
le gabarit supplémentaire (61) est installé dans une position et une posture où le film (91) est maintenu à l'écart de la sous-couche (92) après que le film est détaché de la sous-couche lorsque le gabarit de vibration entre dans l'interface.

4. Machine à décoller des films selon la revendication 1,
dans laquelle le bord du film (91) est un coin du film, et le mécanisme d'application de gabarit (5) est un mécanisme destiné à appliquer le gabarit de vibration (42) de manière à générer la vibration ultrasonore dans l'interface du film et de la sous-couche au coin du film.

5. Machine à décoller des films selon la revendication 4,
dans laquelle le mécanisme d'application de gabarit (5) est un mécanisme destiné à faire entrer le gabarit de vibration (42) dans l'interface du film et de la sous-couche au coin du film.

6. Machine à décoller des films selon la revendication 5, dans laquelle un gabarit supplémentaire (61) est installé derrière le gabarit de vibration (42) dans une direction d'entrée, et
le gabarit supplémentaire est installé dans une position et une posture où le film (91) est maintenu à l'écart de la sous-couche (92) après que le film est détaché de la sous-couche lorsque le gabarit de vibration (42) est entré dans l'interface.

7. Machine à décoller des films selon l'une quelconque des revendications précédentes,
dans laquelle les moyens d'arrachement ont un dispositif de pincement (53) pour pincer et maintenir le bord du film (91), un mandrin pour monter en mandrin et maintenir le bord du film, ou un gabarit de collage pour coller et maintenir le bord du film.

8. Machine à décoller des films selon l'une quelconque des revendications précédentes,
comprenant en outre un moniteur de décollement pour surveiller une situation à décoller des films,
dans laquelle le moniteur de décollement a une caméra (71) pour capturer le substrat complet après que les moyens d'arrachement (53) ont fonctionné, et un module de traitement d'image pour juger si le film a été entièrement décollé en traitant des données d'image provenant de la caméra.

9. Machine à décoller des films selon l'une quelconque des revendications précédentes,
comprenant en outre une commande (3) pour commander le gabarit de vibration (42) et la source d'ultrasons (41), dans laquelle la commande (3) peut réaliser une commande là où le gabarit de vibration est appliqué pour faire contact immédiat avec le film (91) et la sous-couche (92) pendant qu'il est soumis à des vibrations ultrasonores par la source d'ultrasons.

10. Machine à décoller des films selon l'une quelconque des revendications précédentes,
dans laquelle le gabarit de vibration (42) est en forme de plaque.

11. Machine à décoller des films selon l'une quelconque des revendications précédentes,
dans laquelle le gabarit de vibration (42) est en forme de broche, en forme de fil ou en forme de tige.
